# EUROPEAN PATENT APPLICATION

(11) **EP 4 156 292 A1**
(43) Date of publication of application: **29.03.2023**
(21) Application number: 22184397.2
(22) Date of filing: 12.07.2022
(51) Int. Cl.: H01L 29/775, H01L 21/336, H01L 29/423, H01L 29/51, H01L 29/06, H01L 29/49, B82Y 10/00, H01L 29/08, H01L 29/165

(54) **SEMICONDUCTOR DEVICE**

(30) Priority: 24.09.2021 KR 20210126133
(71) Applicant: Samsung Electronics Co., Ltd., Gyeonggi-do, 16677 (KR)
(72) Inventor: YU, Hae Jun, Suwon-si, Gyeonggi-do 16677 (KR); SHIN, Dong Suk, Suwon-si, Gyeonggi-do 16677 (KR); JUNG, Soon Wook, Suwon-si, Gyeonggi-do 16677 (KR); CHOI, Kyung In, Suwon-si, Gyeonggi-do 16677 (KR)
(74) Representative: Kuhnen & Wacker Patent- und Rechtsanwaltsbüro PartG mbB

(57) **Abstract**

A semiconductor device includes an active pattern which includes a lower pattern extending in a first direction, and sheet patterns spaced apart from the lower pattern in a second direction perpendicular to an upper surface of the lower pattern, each sheet pattern including an upper surface and a lower surface, a gate structure disposed on the lower pattern and including a gate electrode and a gate insulating film, the gate electrode and the gate insulating film surrounding each sheet pattern, and a source/drain pattern disposed on at least one side of the gate structure. The gate structure includes inter-gate structures that are disposed between the lower pattern and a lowermost sheet pattern and between two sheet patterns, and contacts the source/drain pattern. The gate insulating film includes a horizontal portion with a first thickness, and a first vertical portion with a second thickness different from the first thickness.

## Description

This application claims priority from Korean Patent Application No. 10-2021-0126133 filed on September 24, 2021 in the Korean Intellectual Property Office, the disclosure of which is incorporated herein by reference in its entirety.

### BACKGROUND

### 1. Field of the Invention

The present invention relates to a semiconductor device, and more specifically, to a semiconductor device including an MBCFET^{™} (Multi-Bridge Channel Field Effect Transistor).

### 2. Description of the Related Art

As one of scaling technologies for increasing density of semiconductor devices, a multi gate transistor in which a fin or nanowire-shaped multi-channel active pattern (or a silicon body) is formed on a substrate, and a gate electrode is formed on a surface of the multi-channel active pattern was proposed.

Since such a multi gate transistor utilizes three-dimensional channels, scaling is easily performed, and without increasing a gate width, current control capability may be improved. Furthermore, a SCE (short channel effect) in which a potential of a channel region is influenced by a drain voltage may be effectively suppressed.

### SUMMARY

Aspects of the present invention provide a semiconductor device capable of improving element performance and reliability.

However, aspects of the present invention are not restricted to the one set forth herein. The above and other aspects of the present invention will become more apparent to one of ordinary skill in the art to which the present invention pertains by referencing the detailed description of the present invention given below.

According to an embodiment of the present invention, a semiconductor device includes an active pattern which includes a lower pattern extending in a first direction, and a plurality of sheet patterns spaced apart from the lower pattern in a second direction perpendicular to an upper surface of the lower pattern, each sheet pattern including an upper surface and a lower surface opposite to each other in the second direction, a gate structure which is disposed on the lower pattern and includes a gate electrode and a gate insulating film, the gate electrode and the gate insulating film surrounding each sheet pattern, and a source/drain pattern disposed on at least one side of the gate structure. The gate structure includes a plurality of inter-gate structures. A lowermost inter-gate structure is disposed between the lower pattern and a lowermost sheet pattern. Each inter-gate structure is between two sheet patterns adjacent to each other in the second direction. The gate structure contacts the source/drain pattern. The gate insulating film includes a horizontal portion extending along an upper surface of each sheet pattern and a lower surface of each sheet pattern, and a first vertical portion extending along the source/drain pattern. A thickness, in the second direction, of the horizontal portion of the gate insulating film is different from a thickness, in the first direction, of the first vertical portion of the gate insulating film.

According to an embodiment of the present invention, a semiconductor device includes an active pattern which includes a lower pattern extending in a first direction, and a plurality of sheet patterns spaced apart from the lower pattern in a second direction perpendicular to an upper surface of the lower pattern, each of the plurality of sheet patterns including an upper surface and a lower surface opposite to each other in the second direction, a gate structure which is disposed on the lower pattern and includes a gate electrode and a gate insulating film, the gate electrode and the gate insulating film surrounding each of the plurality of sheet patterns, and a source/drain pattern which is disposed on at least one side of the gate structure. The gate structure includes a plurality of inter-gate structures. A lowermost inter-gate structure is disposed between the lower pattern and a lowermost sheet pattern. Each of other inter-gate structures is disposed between corresponding two sheet patterns adjacent to each other in the second direction. The gate insulating film includes an interfacial insulating film, and a high-dielectric constant insulating film disposed between the interfacial insulating film and the gate electrode. The interfacial insulating film includes a horizontal portion extending along an upper surface of each sheet pattern and a lower surface thereof, and a first vertical portion extending along the source/drain pattern. A thickness, in the second direction, of the horizontal portion of the interfacial insulating film is different from a thickness, in the first direction, of the first vertical portion of the interfacial insulating film.

According to an embodiment of the present invention, a semiconductor device includes an active pattern which includes a lower pattern extending in a first direction, and a plurality of sheet patterns spaced apart from the lower pattern in a second direction perpendicular to an upper surface of the lower pattern, each sheet pattern including an upper surface and a lower surface opposite to each other in the second direction, a gate structure which is disposed on the lower pattern and includes a gate electrode and a gate insulating film, the gate electrode and the gate insulating film surrounding each sheet pattern, a gate spacer disposed on opposite side walls of the gate structure, and a source/drain pattern which is disposed on at least one side of the gate structure. The gate insulating film includes an interfacial insulating film, and a high-dielectric constant insulating film disposed between the interfacial insulating film and the gate electrode. The interfacial insulating film does not extend along side walls of the gate spacer. The high-dielectric constant insulating film extends along the side walls of the gate spacer. The interfacial insulating film includes a horizontal portion extending along an upper surface of each sheet pattern and a lower surface thereof, and a first vertical portion extending along the source/drain pattern and contacting the source/drain pattern. A thickness, in the second direction, of the horizontal portion of the interfacial insulating film is different from a thickness, in the first direction, of the first vertical portion of the interfacial insulating film.

### BRIEF DESCRIPTION OF THE DRAWINGS

The above and other aspects and features of the present disclosure will become more apparent by describing exemplary embodiments thereof in detail with reference to the attached drawings, in which:
FIG. 1 is an exemplary plan view for explaining the semiconductor device according to some embodiments;
FIGS. 2 and 3 are cross-sectional views taken along A-A and B-B of FIG. 1;
FIG. 4 is an enlarged view showing a region P of FIG. 2;
FIG. 5 is an enlarged view showing a region Q of FIG. 3;
FIG. 6 is a diagram for explaining a semiconductor device according to some embodiments;
FIGS. 7 and 8 are diagrams for explaining a semiconductor device according to some embodiments;
FIG. 9 is a diagram for explaining a semiconductor device according to some embodiments;
FIG. 10 is a diagram for explaining a semiconductor device according to some embodiments;
FIG. 11 is a diagram for explaining the semiconductor device according to some embodiments;
FIG. 12 is a diagram for explaining a semiconductor device according to some embodiments;
FIG. 13 is a diagram for explaining the semiconductor device according to some embodiments;
FIG. 14 is a diagram for explaining a semiconductor device according to some embodiments;
FIGS. 15 to 20 are intermediate stage diagrams for explaining a method for manufacturing a semiconductor device according to some embodiments.

### DETAILED DESCRIPTION OF THE EMBODIMENTS

A semiconductor device according to some embodiments may include a tunneling transistor (tunneling FET), a three-dimensional (3D) transistor, or a transistor based on two-dimensional material (2D material-based FETs), and a heterogeneous structure thereof. Further, the semiconductor device according to some embodiments may include a bipolar junction transistor, a laterally diffused metal oxide semiconductor (LDMOS), or the like.

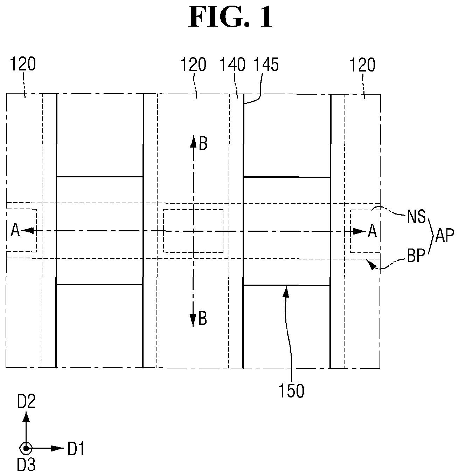

The semiconductor device according to some embodiments will be described referring to FIGS. 1 to 5.

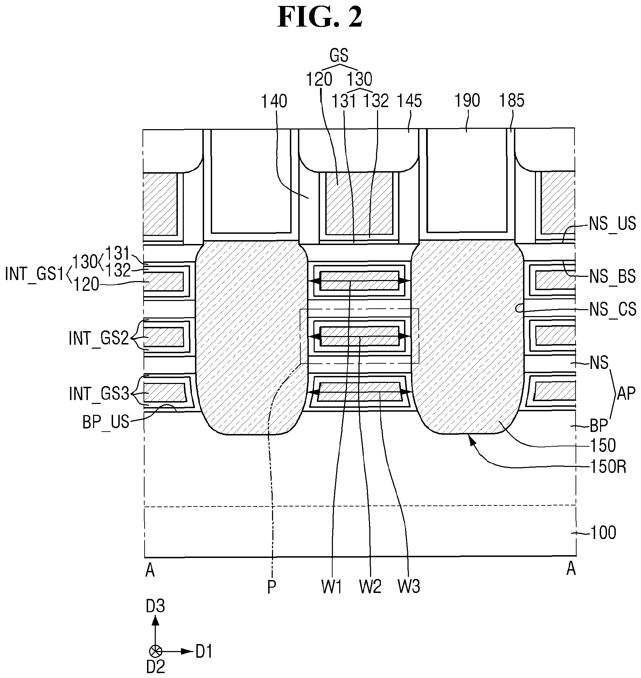

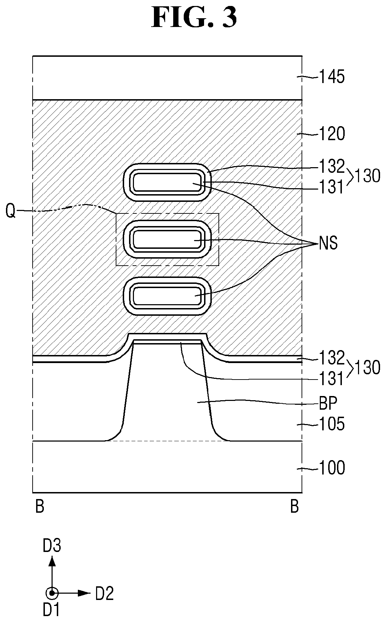

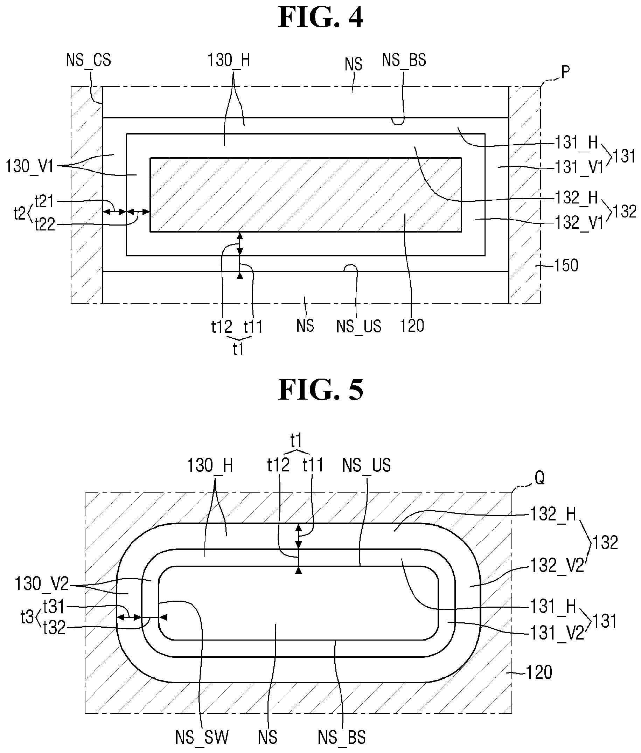

FIG. 1 is an exemplary plan view for explaining the semiconductor device according to some embodiments. FIGS. 2 and 3 are cross-sectional views taken along A-A and B-B of FIG. 1. FIG. 4 is an enlarged view showing a region P of FIG. 2. FIG. 5 is an enlarged view showing a region Q of FIG. 3.

FIG. 1 is simply shown except for a gate insulating film 130, an etching stop film 185, an interlayer insulating film 190, and the like.

Referring to FIGS. 1 to 5, the semiconductor device according to some embodiments may include an active pattern AP, a plurality of gate structures GS, and a source/drain pattern 150.

The substrate 100 may be bulk silicon or silicon-on-insulator (SOI). In some embodiments, the substrate 100 may be a silicon substrate, or may include, but is not limited to, other materials, for example, silicon germanium, silicon germanium on insulator (SGOI), indium antimonide, lead tellurium compounds, indium arsenic, indium phosphate, gallium arsenide or antimonide gallium.

The active pattern AP may be disposed on the substrate 100. The active pattern AP may extend long in a first direction D1. In an example, the active pattern AP may be disposed in a region in which a P-type metal oxide semiconductor (PMOS) is formed. In another example, the active pattern AP may be disposed in a region in which an N-type metal oxide semiconductor (NMOS) is formed.

The active pattern AP may be a multi-channel active pattern. The active pattern AP may include a lower pattern BP and a plurality of sheet patterns NS. The lower pattern BP may protrude from the substrate 100. The lower pattern BP may extend long in the first direction D1.

The plurality of sheet patterns NS may be disposed on an upper surface BP US of the lower pattern. The plurality of sheet patterns NS may be spaced apart from the lower pattern BP in a third direction D3. The sheet patterns NS may be spaced apart from each other in the third direction D3.

Each of the sheet patterns NS may include an upper surface NS US and a lower surface NS BS. The upper surface NS US of the sheet pattern is a surface that is opposite to the lower surface NS BS of the sheet pattern in the third direction D3. Each of the sheet patterns NS may include connecting surfaces NS CS opposite to each other in the first direction D1, and side walls NS SW opposite to each other in the second direction D2. It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element, there are no intervening elements present at the point of contact.

The upper surface NS US of the sheet pattern and the lower surface NS BS of the sheet pattern may be connected with each other using the connecting surfaces NS CS of the sheet pattern. The upper surface NS US of the sheet pattern and the lower surface NS BS of the sheet pattern may be connected with each other using the side walls NS SW of the sheet pattern. It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element, there are no intervening elements present at the point of contact.

The connecting surfaces NS CS of the sheet pattern are connected to a source/drain pattern 150 to be described later. In some embodiments, the connecting surfaces NS CS of the sheet pattern contact the source/drain pattern 150. The connecting surfaces NS CS of the sheet pattern may be boundary surfaces between the sheet pattern NS and the source/drain pattern 150.

In FIGS. 3 and 5, although the side walls NS SW of the sheet pattern are shown to be a combination of a curved surface portion and a flat surface portion, the embodiment is not limited thereto. In some embodiments, the side walls NS SW of the sheet pattern may be a curved surface as a whole or a flat surface as a whole.

The third direction D3 may be a direction that intersects the first direction D1 and the second direction D2. For example, the third direction D3 may be a thickness direction of the substrate 100. The first direction D1 may be a direction that intersects the second direction D2. In some embodiments, the first and second directions D1 and D2 may be a direction parallel to an upper surface of the lower pattern BP, and the third direction D3 may be a direction perpendicular to the upper surface of the lower pattern BP.

The three sheet patterns NS are shown as being disposed in the third direction D3. The present invention is not limited thereto. In some embodiments, more than three sheet patterns may be stacked on each other in the third direction D3.

The lower pattern BP may be formed by etching a part of the substrate 100, or may include an epitaxial layer that is grown from the substrate 100. The lower pattern BP may include or may be formed of silicon or germanium, which is an elemental semiconductor material. In some embodiments, the lower pattern BP may include or may be formed of a compound semiconductor such as a group IV-IV compound semiconductor and a group III-V compound semiconductor. In some embodiments, the lower pattern BP may protrude from a top surface of the substrate 100. It should be noted that in some embodiments, the lower pattern BP may be part of the substrate 100, and in this manner, protruding from the substrate 100 refers to protruding past a top surface of the substrate (e.g., wherein the substrate itself has protrusions that extend beyond a main surface thereof). The lower pattern BP may be referred to as a fin or a fin pattern.

The group IV-IV compound semiconductor may include or may be formed of, for example, a binary compound, a ternary compound including at least two or more of carbon (C), silicon (Si), germanium (Ge), and tin (Sn), or a compound obtained by doping the binary or ternary compounds with a group IV element.

The group III-V compound semiconductor may be, for example, at least one of a binary compound, a ternary compound and a quaternary compound formed by combining at least one of aluminum (Al), gallium (Ga) and indium (In) as a group III element with one of phosphorus (P), arsenic (As) and antimony (Sb) as a group V element

The sheet pattern NS may include or may be formed of one of silicon or germanium which is an elemental semiconductor material, a group IV-IV compound semiconductor and a group III-V compound semiconductor. Each of the sheet patterns NS may include or may be formed of the same material as the lower pattern BP, and may include or may be formed of a material different from the lower pattern BP.

In the semiconductor device according to some embodiments, the lower pattern BP may be a silicon lower pattern including or being formed of silicon, and the sheet pattern NS may be a silicon sheet pattern including or being formed of silicon.

A width of the sheet pattern NS in the second direction D2 may increase or decrease in proportion to a width of the lower pattern BP in the second direction D2. In some embodiments, the widths in the second direction D2 of the sheet patterns NS stacked in the third direction D3 are shown as being the same as each other. The present invention is not limited thereto. In some embodiments, unlike the shown example, the width in the second direction D2 of the sheet patterns NS stacked in the third direction D3 may decrease, when the width of the sheet patterns NS is measured along a straight line extending in the second direction D3 away from the lower pattern BP.

The field insulating film 105 may be formed on the substrate 100. The field insulating film 105 may be disposed on the side walls of the lower pattern BP. The field insulating film 105 is not disposed on the upper surface BP US of the lower pattern.

In some embodiments, the field insulating film 105 may completely cover the side walls of the lower pattern BP. In some embodiments, unlike the shown example, the field insulating film 105 may cover a part of the side walls of the lower pattern BP. In this case, a part of the lower pattern BP may protrude from the upper surface of the field insulating film 105 in the third direction D3.

Each of the sheet patterns NS is disposed to be higher than the upper surface of the field insulating film 105. The field insulating film 105 may include or may be, for example, an oxide film, a nitride film, an oxynitride film or a combination film thereof. The field insulating film 105 is shown as a single film. The present invention is not limited thereto. In some embodiments, the field insulating film 105 may be a multi-layered film.

A plurality of gate structures GS may be disposed on the substrate 100. Each gate structure GS may extend in the second direction D2. The gate structures GS may be disposed apart from each other in the first direction D1. The gate structures GS may be adjacent to each other in the first direction D1.

The gate structure GS may be disposed on the active pattern AP. The gate structure GS may intersect the active pattern AP. The gate structure GS may intersect the lower pattern BP. The gate structure GS may wrap each of the sheet patterns NS. The gate structure GS may include, for example, a gate electrode 120 and a gate insulating film 130.

The gate structure GS may include inter-gate structures INT_GS1, INT_GS2 and INT_GS3 disposed between the sheet patterns NS adjacent to each other in the third direction D3, and between the lower pattern BP and the sheet pattern NS. The inter-gate structures INT_GS1, INT_GS2, and INT_GS3 may be disposed between the upper surface BP_US of the lower pattern and a lower surface NS BS of the lowermost sheet pattern, and between the upper surface NS_US of the sheet pattern and the lower surface NS_BS of the sheet pattern facing each other in the third direction D3.

The number of inter-gate structures INT_GS1, INT_GS2 and INT_GS3 may be proportional to the number of sheet patterns NS included in the active pattern AP. For example, the number of inter-gate structures INT_GS1, INT_GS2 and INT_GS3 may be equal to the number of sheet patterns NS. Since the active pattern AP includes a plurality of sheet patterns NS, the gate structure GS may include a plurality of inter-gate structures.

The inter-gate structures INT_GS1, INT_GS2 and INT_GS3 contact the source/drain pattern 150 to be described below. For example, the inter-gate structures INT_GS1, INT_GS2 and INT_GS3 may be in direct contact with the source/drain pattern 150. The inter-gate structures INT_GS1, INT_GS2, and INT_GS3 contact the upper surface BP_US of the lower pattern, the upper surface NS_US of the sheet pattern, and the lower surface NS_BS of the sheet pattern.

The following description will be provided using a case where the number of inter-gate structures INT_GS1, INT_GS2, and INT_GS3 is three.

The gate structure GS may include a first inter-gate structure INT_GS1, a second inter-gate structure INT_GS2, and a third inter-gate structure INT_GS3. The first inter-gate structure INT_GS1, the second inter-gate structure INT_GS2, and the third inter-gate structure INT_GS3 may be sequentially disposed on the lower pattern BP.

The third inter-gate structure INT_GS3 may be disposed between the lower pattern BP and the sheet pattern NS. The third inter-gate structure INT_GS3 may be disposed at the lowermost parts of the inter-gate structures INT_GS1, INT_GS2, and INT_GS3. The third inter-gate structure INT GS3 may be in contact with the upper surface BP_US of the lower pattern.

The first inter-gate structure INT_GS1 and the second inter-gate structure INT_GS2 may be disposed between the sheet patterns NS adjacent to each other in the third direction D3. The first inter-gate structure INT_GS1 may be disposed at the uppermost parts of the inter-gate structures INT_GS1, INT_GS2, and INT_GS3. The first inter-gate structure INT_GS1 may be in contact with the lower surface NS_BS of the uppermost sheet pattern. The second inter-gate structure INT_GS2 may be disposed between the first inter-gate structure INT GS 1 and the third inter-gate structure INT_GS3.

The inter-gate structures INT_GS1, INT_GS2 and INT_GS3 may include a gate electrode 120 and a gate insulating film 130 disposed between adjacent sheet patterns NS, and between the lower pattern BP and the sheet pattern NS.

For example, a width W1 of the first inter-gate structure INT_GS1 in the first direction D1 may be equal to a width W2 of the second inter-gate structure INT_GS2 in the first direction D1. In the semiconductor device according to some embodiments, the widths of the inter-gate structures INT_GS1 and INT_GS2 disposed between the sheet patterns NS adjacent to each other in the third direction D3 may be equal to each other.

For example, a width W3 of the third inter-gate structure INT_GS3 in the first direction D1 may be greater than the width W2 of the second inter-gate structure INT_GS2 in the first direction D1. The present invention is not limited thereto. In some embodiments, unlike the shown example, the width W3 of the third inter-gate structure INT_GS3 in the first direction D1 may be equal to the width W2 of the second inter-gate structure INT_GS2 in the first direction D1.

For the simplicity of description, the second inter-gate structure INT_GS2 will be described as an example. The width W2 of the second inter-gate structure INT_GS2 may be measured in the middle between the upper surface NS_US of the sheet pattern and the lower surface NS_NS of the sheet pattern facing each other in the third direction D3.

The gate electrode 120 may be formed on the lower pattern BP. The gate electrode 120 may intersect the lower pattern BP. The gate electrode 120 may wrap the sheet pattern NS.

A part of the gate electrode 120 may be disposed between the adjacent sheet patterns NS, and between the lower pattern BP and the sheet pattern NS. When the sheet pattern NS includes the first sheet pattern and the second sheet pattern adjacent to each other in the third direction D3, a part of the gate electrode 120 may be disposed between the upper surface NS_US of the first sheet pattern and the lower surface NS_BS of the second sheet pattern facing each other. A part of the gate electrode 120 may be disposed between the upper surface BS_US of the lower pattern and the lower surface NS_BS of the lowermost sheet pattern. The first sheet pattern may be the lowermost sheet pattern or may not be the lowermost sheet pattern.

The gate electrode 120 may include or may be formed of at least one of metal, a metal alloy, a conductive metal nitride, a metal silicide, a doped semiconductor material, a conductive metal oxide, and a conductive metal oxynitride. The gate electrode 120 may include or may be formed of, for example, but is not limited to, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof. The conductive metal oxide and the conductive metal oxynitride may include or may be, but are not limited to, the oxidized form of the above-mentioned materials.

The gate electrodes 120 may be disposed on both sides of the source/drain pattern 150 to be described later. The gate structure GS may be disposed on both sides of the source/drain pattern 150 in the first direction D1.

In some embodiments, both the gate electrodes 120 disposed on opposite sides of the source/drain pattern 150 may be normal gate electrodes used as a gate electrode of a transistor. The present invention is not limited thereto. In some embodiments, the gate electrode 120 disposed on one side of the source/drain pattern 150 is used as the gate of the transistor, but the gate electrode 120 disposed on the other side of the source/drain pattern 150 may be a dummy gate electrode. The dummy gate electrode is a conductive line formed at the same level and adjacent to normal gate electrodes of transistors. The dummy gate electrode is patterned or formed from the same conductive layer(s). For example, the dummy gate electrode may not serve as a gate electrode of a transistor, and thus the dummy gate line may not be activated or if activated, may not result in operation of any transistor.

The gate insulating film 130 may extend along the upper surface of the field insulating film 105 and the upper surface BP US of the lower pattern. The gate insulating film 130 may wrap a plurality of sheet patterns NS. The gate insulating film 130 may be disposed along the periphery of the sheet pattern NS. The gate electrode 120 is disposed on the gate insulating film 130. The gate insulating film 130 is disposed between the gate electrode 120 and the sheet pattern NS.

A part of the gate insulating film 130 may be disposed between the sheet patterns NS adjacent to each other in the third direction D3, and between the lower pattern BP and the sheet pattern NS. When the sheet pattern NS includes the first sheet pattern and the second sheet pattern adjacent to each other, a part of the gate insulating film 130 may extend along the upper surface NS US of the first sheet pattern and the lower surface NS BS of the second sheet pattern facing each other.

The gate insulating film 130 may include a horizontal portion 130 H, a first vertical portion 130_V1, and a second vertical portion 130_V2. The horizontal portion 130_H of the gate insulating film may extend along the upper surface NS_US of the sheet pattern and the lower surface NS_BS of the sheet pattern. The horizontal portion 130_H of the gate insulating film may extend along the upper surface BP_US of the lower pattern.

The first vertical portion 130_V1 of the gate insulating film may extend along the source/drain pattern 150. The second vertical portion 130_V2 of the gate insulating film may extend along the side walls NS SW of the sheet pattern. The horizontal portion 130_H of the gate insulating film and the first vertical portion 130_V1 of the gate insulating film may be included in the inter-gate structures INT_GS1, INT_GS2, and INT_GS3.

The gate insulating film 130 may include an interfacial insulating film 131 and a high-dielectric constant insulating film 132. The high-dielectric constant insulating film 132 may be disposed between the interfacial insulating film 131 and the gate electrode 120.

The interfacial insulating film 131 may extend along the upper surface BP US of the lower pattern. The interfacial insulating film 131 may extend along the source/drain pattern 150. The interfacial insulating film 131 may be disposed along the periphery of the sheet pattern NS. The interfacial insulating film 131 may not extend along the side walls of the gate spacer 140 to be described later. The interfacial insulating film 131 may be in contact with the lower pattern BP, the source/drain pattern 150, and the sheet pattern NS.

The high-dielectric constant insulating film 132 may extend along the upper surface of the field insulating film 105 and the upper surface BP US of the lower pattern. The high-dielectric constant insulating film 132 may extend along the source/drain pattern 150. The high-dielectric constant insulating film 132 may be disposed along the periphery of the sheet pattern NS. The high-dielectric constant insulating film 132 may extend along the side walls of the gate spacer 140 to be described later.

The interfacial insulating film 131 may include a horizontal portion 131_H, a first vertical portion 131_V1, and a second vertical portion 131_V2. The high-dielectric constant insulating film 132 may include a horizontal portion 132_H, a first vertical portion 132_V1, and a second vertical portion 132_V2.

The horizontal portion 131_H of the interfacial insulating film and the horizontal portion 132_H of the high-dielectric constant insulating film may extend along the upper surface NS_US of the sheet pattern and the lower surface NS_BS of the sheet pattern. The horizontal portion 131_H of the interfacial insulating film and the horizontal portion 132_H of the high-dielectric constant insulating film may extend along the upper surface BP_US of the lower pattern.

The first vertical portion 131_V1 of the interfacial insulating film and the first vertical portion 132_V1 of the high-dielectric constant insulating film may extend along the source/drain pattern 150. The second vertical portion 131_V2 of the interfacial insulating film and the second vertical portion 132_V2 of the high-dielectric constant insulating film may extend along the side walls NS_SW of the sheet pattern.

The horizontal portion 130_H of the gate insulating film includes the horizontal portion 131_H of the interfacial insulating film and the horizontal portion 132_H of the high-dielectric constant insulating film. The first vertical portion 130_V1 of the gate insulating film includes a first vertical portion 131_V1 of the interfacial insulating film and a first vertical portion 132_V1 of the high-dielectric constant insulating film. The second vertical portion 130_V2 of the gate insulating film includes a second vertical portion 131_V2 of the interfacial insulating film and a second vertical portion 132_V2 of the high-dielectric constant insulating film.

The horizontal portion 131_H of the interfacial insulating film, the horizontal portion 132 H of the high-dielectric constant insulating film, the first vertical portion 131_V1 of the interfacial insulating film, and the first vertical portion 132_V1 of the high-dielectric constant insulating film may be included in the inter-gate structures INT_GS1, INT_GS2 and INT_GS3.

A thickness t1 of the horizontal portion 130_H of the gate insulating film in the third direction D3 is different from a thickness t2 of the first vertical portion 130_V1 of the gate insulating film in the first direction D1. For example, the thickness t1 of the horizontal portion 130_H of the gate insulating film in the third direction D3 is smaller than the thickness t2 of the first vertical portion 130_V1 of the gate insulating film in the first direction D1.

The thickness t1 of the horizontal portion 130_H of the gate insulating film in the third direction D3 may be equal to a thickness t3 of the second vertical portion 130_V2 of the gate insulating film in the second direction D2.

A thickness t11 of the horizontal portion 131_H of the interfacial insulating film in the third direction D3 is different from a thickness t21 of the first vertical portion 131_V1 of the interfacial insulating film in the first direction D1. For example, the thickness t11 of the horizontal portion 131_H of the interfacial insulating film in the third direction D3 is smaller than the thickness t21 of the first vertical portion 131_V1 of the interfacial insulating film in the first direction D1.

The first vertical portion 131_V1 of the interfacial insulating film may be formed at a uniform thickness along the source/drain pattern 150.

By forming the thickness t21 of the first vertical portion 131_V1 of the interfacial insulating film to be greater than the thickness t11 of the horizontal portion 131_H of the interfacial insulating film, a leakage current between the gate electrode 120 and the source/drain pattern 150 can be effectively reduced.

The thickness t11 of the horizontal portion 131_H of the interfacial insulating film in the third direction D3 may be equal to a thickness t31 of the second vertical portion 131_V2 of the interfacial insulating film in the second direction D2.

The thickness t12 of the horizontal portion 132_H of the high-dielectric constant insulating film in the third direction D3 may be equal to a thickness t22 of the first vertical portion 132_V1 of the high-dielectric constant insulating film in the first direction D1. The thickness t12 of the horizontal portion 132_H of the high-dielectric constant insulating film in the third direction D3 may be equal to a thickness t32 of the second vertical portion 132_V2 of the high-dielectric constant insulating film in the second direction D2.

The interfacial insulating film 131 may include or may be formed of at least one of silicon oxide, silicon-germanium oxide, and germanium oxide. The interfacial insulating film 131 may further include at least one of boron (B), phosphorus (P), carbon (C), arsenic (As), antimony (Sb) and bismuth (Bi).

The high-dielectric constant insulating film 132 may include or may be formed of, for example, one or more of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide and lead zinc niobate.

The semiconductor device according to some other embodiments may include an NC (Negative Capacitance) FET that uses a negative capacitor. In some embodiments, the high-dielectric constant insulating film 132 may include or may be formed of a ferroelectric material film having ferroelectric properties. In some embodiments, the high-dielectric constant insulating film 132 may include or may be formed of a ferroelectric material film having ferroelectric properties and a paraelectric material film having paraelectric properties.

The ferroelectric material film may have a negative capacitance, and the paraelectric material film may have a positive capacitance. For example, when two or more capacitors are connected with each other in series, and the capacitance of each capacitor has a positive value, the entire capacitance decreases from the capacitance of each individual capacitor. In some embodiments, when at least one of the capacitances of two or more capacitors connected in series has a negative value, the entire capacitance may be greater than an absolute value of each individual capacitance, while having a positive value.

When the ferroelectric material film having the negative capacitance and the paraelectric material film having the positive capacitance are connected with each other in series, the overall capacitance values of the ferroelectric material film and the paraelectric material film connected in series may increase. By the use of the increased overall capacitance value, a transistor including the ferroelectric material film may have a subthreshold swing (SS) less than 60 mV/decade at the room temperature.

The ferroelectric material film may have ferroelectric properties. The ferroelectric material film may include or may be formed of, for example, at least one of hafnium oxide, hafnium zirconium oxide, barium strontium titanium oxide, barium titanium oxide, and lead zirconium titanium oxide. For example, the hafnium zirconium oxide may be a material obtained by doping hafnium oxide with zirconium (Zr). In some embodiments, the hafnium zirconium oxide may be a compound of hafnium (Hf), zirconium (Zr), and oxygen (O).

The ferroelectric material film may further include a doped dopant. For example, the dopant may be at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material film may vary, depending on which type of ferroelectric material is included in the ferroelectric material film.

When the ferroelectric material film includes or is formed of hafnium oxide, the dopant included in the ferroelectric material film may be, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. A ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have paraelectric properties. The paraelectric material film may include or may be formed of at least one of, for example, a silicon oxide and a metal oxide having a high dielectric constant. The metal oxide included in the paraelectric material film may include or may be formed of, for example, but is not limited to, at least one of hafnium oxide, zirconium oxide, and aluminum oxide.

The ferroelectric material film and the paraelectric material film may include or may be formed of the same material as each other. The ferroelectric material film has the ferroelectric properties, but the paraelectric material film may not have the ferroelectric properties. For example, when each of the ferroelectric material film and the paraelectric material film includes or is formed of hafnium oxide, a crystal structure of hafnium oxide of the ferroelectric material film is different from a crystal structure of hafnium oxide of the paraelectric material film.

The ferroelectric material film may have a thickness having the ferroelectric properties. A thickness of the ferroelectric material film may be, for example, but is not limited to, 0.5 to 10 nanometer (nm). Since a critical thickness that exhibits the ferroelectric properties may vary for each ferroelectric material, the thickness of the ferroelectric material film may vary depending on the ferroelectric material.

In some embodiments, the high-dielectric constant insulating film 132 may include or may be formed of one ferroelectric material film. In some embodiments, the high-dielectric constant insulating film 132 may include or may be formed of a plurality of ferroelectric material films spaced apart from each other. The high-dielectric constant insulating film 132 may have a stacked film structure in which a plurality of ferroelectric material films and a plurality of paraelectric material films are alternately stacked on each other.

The gate spacer 140 may be disposed on the side walls of the gate electrode 120. The gate spacer 140 is not disposed between the lower pattern BP and the sheet pattern NS, and between the sheet patterns NS adjacent to each other in the third direction D3.

The gate spacer 140 may include or may be formed of, for example, but is not limited to, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof. Although the gate spacer 140 is shown as a single film, this is only for convenience of explanation, and the embodiment is not limited thereto.

A gate capping pattern 145 may be disposed on the gate structure GS and the gate spacer 140. An upper surface of the gate capping pattern 145 may be disposed on the same plane as the upper surface of the interlayer insulating film 190. The present invention is not limited thereto. In some embodiments, unlike the shown example, the gate capping pattern 145 may be disposed between the gate spacers 140.

The gate capping pattern 145 may include or may be formed of, for example, at least one of silicon nitride (SiN), silicon oxynitride (SiON), silicon carbonitride (SiCN), silicon oxycarbonitride (SiOCN), and combinations thereof. The gate capping pattern 145 may include or may be formed of a material having etching selectivity with respect to the interlayer insulating film 190.

A source/drain pattern 150 may be formed on the active pattern AP. The source/drain pattern 150 may be disposed on the lower pattern BP. The source/drain pattern 150 is connected to the sheet pattern NS. The source/drain pattern 150 contacts the sheet pattern NS.

The source/drain pattern 150 may be disposed on the side surface of the gate structure GS. The source/drain pattern 150 may be disposed between the gate structures GS adjacent to each other in the first direction D1. For example, the source/drain pattern 150 may be disposed on opposite sides of the gate structure GS. In some embodiments, unlike the shown example, the source/drain pattern 150 may be disposed on one side of the gate structure GS and may not be disposed on the other side of the gate structure GS.

The source/drain pattern 150 may be included in the source/drain of a transistor that uses the sheet pattern NS as a channel region.

The source/drain pattern 150 may be disposed inside a source/drain recess 150R. The source/drain recess 150R extends in the third direction D3. The source/drain recess 150R may be defined between the gate structures GS adjacent to each other in the first direction D1.

A bottom surface of the source/drain recess 150R may be defined by the lower pattern BP. The side walls of the source/drain recess 150R may be defined by the sheet pattern NS and the inter-gate structures INT_GS1, INT_GS2 and INT_GS3. The side walls of the inter-gate structures INT_GS1, INT_GS2 and INT_GS3 may be defined by the gate insulating film 130 of the inter-gate structures INT_GS1, INT_GS2 and INT_GS3.

A boundary between the gate insulating film 130 and the lower pattern BP may be the upper surface BP_US of the lower pattern BP and may be disposed between the nanosheet NS disposed at the lowermost portion (i.e., a lowermost nanosheet among the nanosheets NS) and the lower pattern BP. The upper surface BP_US of the lower pattern BP may be a boundary between the third inter-gate structure INT_GS3 disposed at the lowermost portion (i.e., a lowermost inter-gate structure among the inter-gate structures) and the lower pattern BP. The bottom surface of the source/drain recess 150R is lower than the upper surface BP_US of the lower pattern.

The source/drain pattern 150 may be disposed inside the source/drain recess 150R. The source/drain pattern 150 may fill the source/drain recess 150R.

The source/drain pattern 150 may be in contact with the sheet pattern NS and the lower pattern BP. Since the gate spacer 140 is not disposed between the adjacent nanosheets NS, the interfacial insulating film 131 contacts with the source/drain pattern 150.

The source/drain pattern 150 may include or may be an epitaxial pattern. The source/drain pattern 150 includes or may be formed of a semiconductor material.

The source/drain pattern 150 may include or may be formed of, for example, silicon or germanium, which is an elemental semiconductor material. In some embodiments, the source/drain pattern 150 may include or may be formed of, for example, a binary compound, a ternary compound containing at least two or more of carbon (C), silicon (Si), germanium (Ge), and tin (Sn), or a compound obtained by doping the binary or ternary compounds with a group IV element. For example, the source/drain pattern 150 may include or may be formed of, but is not limited to, silicon, silicon-germanium, germanium, or silicon carbide.

The source/drain pattern 150 may include impurities doped in the semiconductor material. The doped impurities may include or may be at least one of boron (B), phosphorus (P), carbon (C), arsenic (As), antimony (Sb), bismuth (Bi), and oxygen (O).

Although the source/drain pattern 150 is shown as a single film, this is only for convenience of explanation, and the embodiment is not limited thereto.

The etching stop film 185 may extend along the outer walls of the gate spacer 140 and the profile of the source/drain pattern 150. Although not shown, the etching stop film 185 may be disposed on the upper surface of the field insulating film 105.

The etching stop film 185 may include or may be formed of a material having etching selectivity with respect to the interlayer insulating film 190 to be described later. The etching stop film 185 may be, for example, at least one of silicon nitride (SiN), silicon oxynitride (SiON), silicon oxycarbonitride (SiOCN), silicon boronitride (SiBN), silicon oxyboronitride (SiOBN), silicon oxycarbide (SiOC), and combinations thereof.

The interlayer insulating film 190 may be disposed on the etching stop film 185. The interlayer insulating film 190 may be disposed on the source/drain pattern 150. The interlayer insulating film 190 may not cover the upper surface of the gate capping pattern 145. For example, the upper surface of the interlayer insulating film 190 may be disposed on the same plane as the upper surface of the gate capping pattern 145.

The interlayer insulating film 190 may include or may be formed of, for example, at least one of silicon oxide, silicon nitride, silicon oxynitride, and a low-dielectric constant material. The low-dielectric constant material may be, for example, but is not limited to, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate Glass), SiLK, Amorphous Fluorinated Carbon, silica aerogels, silica xerogels, mesoporous silica or combinations thereof.

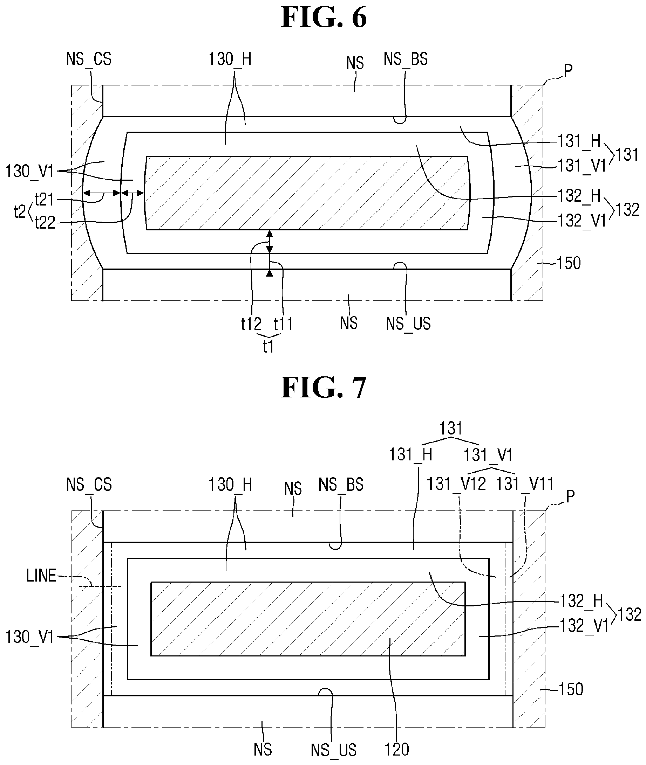

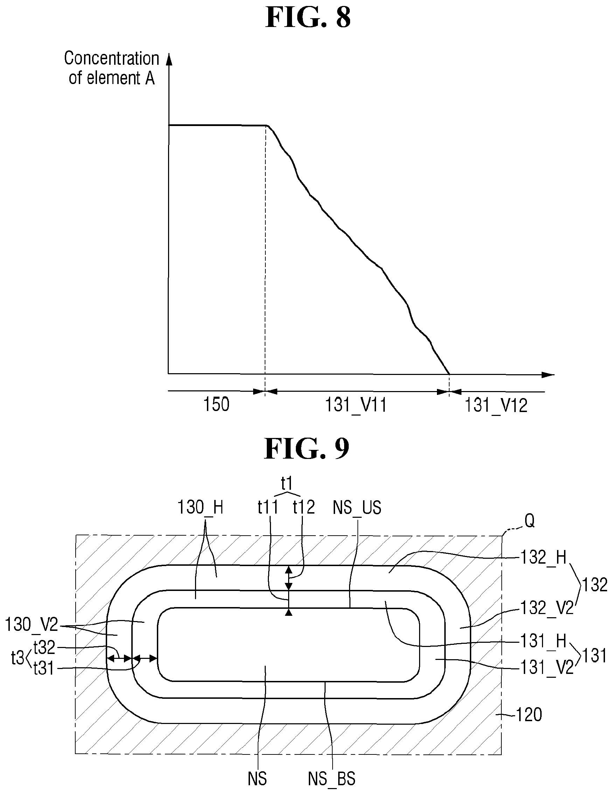

FIG. 6 is a diagram for explaining a semiconductor device according to some embodiments. FIGS. 7 and 8 are diagrams for explaining a semiconductor device according to some embodiments. For convenience of explanation, points different from those described referring to FIGS. 1 to 5 will be described.

For reference, FIGS. 6 and 7 are enlarged views of a region P of FIG. 2. FIG. 8 is a diagram schematically showing the concentration of the element A along a LINE of FIG. 7.

Referring to FIG. 6, in the semiconductor device according to some embodiments, the thickness t21, in the first direction D1, of the first vertical portion 131_V1 of the interfacial insulating film may increases and then decreases, when the thickness t21 is measured along a straight line extending in the third direction D3 away from the sheet pattern NS.

The thickness of the first vertical portion 131_V1 of the interfacial insulating film in the portion adjacent to the sheet pattern NS is smaller than the thickness of the first vertical portion 131_V1 of the interfacial insulating film in the middle between the sheet patterns NS adjacent to each other in the third direction D3.

Referring to FIGS. 7 and 8, in a semiconductor device according to some embodiments, the first vertical portion 131_V1 of the interfacial insulating film may include a first region 131_V11 and a second region 131_V12.

The first region 131_V11 of the first vertical portion of the interfacial insulating film contacts the source/drain pattern 150. The second region 131_V12 of the first vertical portion of the interfacial insulating film may be disposed between the first region 131_V11 of the first vertical portion of the interfacial insulating film and the first vertical portion 132_V1 of the high-dielectric constant insulating film.

The source/drain pattern 150 may include an "A" element other than silicon. For example, the "A" element may be, but is not limited to, one of germanium (Ge), tin (Sn), boron (B), phosphorus (P), carbon (C), arsenic (As), antimony (Sb), bismuth (Bi) and oxygen (O). For example, the source/drain pattern 150 may be doped with a dopant "A" such as germanium (Ge), tin (Sn), boron (B), phosphorus (P), carbon (C), arsenic (As), antimony (Sb), bismuth (Bi) and oxygen (O). The dopant "A" may be an element different from an element forming the source/drain pattern 150. For example, the source/drain pattern 150 is formed of silicon, and the dopant "A" may be one of germanium (Ge), tin (Sn), boron (B), phosphorus (P), carbon (C), arsenic (As), antimony (Sb), bismuth (Bi) and oxygen (O), which are different from silicon.

The concentration of the "A" element in the first region 131_V11 of the first vertical portion of the interfacial insulating film is higher than the concentration of the "A" element in the second region 131_V12 of the first vertical portion of the interfacial insulating film.

For example, in the first region 131_V11 of the first vertical portion of the interfacial insulating film, the concentration of the "A" element may gradually decrease, when the concentration is measured along a straight line extending in the first direction D1 away from the source/drain pattern 150. However, unlike the shown example, in the first region 131_V11 of the first vertical portion of the interfacial insulating film, the concentration of the "A" element is kept constant and then may decrease sharply.

In the second region 131_V12 of the first vertical portion of the interfacial insulating film, the concentration of the "A" element may be close to zero. Here, the expression "the concentration is 0" may mean that the second region 131_V12 of the first vertical portion of the interfacial insulating film does not include the "A" element or includes an "A" element lower than a detection limit of a detection apparatus.

FIG. 8 shows that the concentration of the "A" element in the first region 131_V11 of the first vertical portion of the interfacial insulating film is the same as the concentration of element "A" in the source/drain pattern 150 at the boundary between the first region 131_V11 of the first vertical portion of the interfacial insulating film and the source/drain pattern 150. The present invention is not limited thereto. In some embodiments, the concentration of the "A" element in the first region 131_V11 of the first vertical portion of the interfacial insulating film may be different from the concentration of element "A" in the source/drain pattern 150 at the boundary between the first region 131_V11 of the first vertical portion of the interfacial insulating film and the source/drain pattern 150.

FIG. 9 is a diagram for explaining a semiconductor device according to some embodiments. For convenience of explanation, points different from those described referring to FIGS. 1 to 5 will be described.

For reference, FIG. 9 is an enlarged view showing a region P of FIG. 2.

Referring to FIG. 9, in the semiconductor device according to some embodiments, the thickness t1 of the horizontal portion 130_H of the gate insulating film in the third direction D3 is different from the thickness t3 of the second vertical portion 130_V2 of the gate insulating film in the second direction D2.

For example, the thickness t1 of the horizontal portion 130_H of the gate insulating film in the third direction D3 is smaller than the thickness t3 of the second vertical portion 130_V2 of the gate insulating film in the second direction D2.

The thickness t11 of the horizontal portion 131_H of the interfacial insulating film in the third direction D3 is smaller than the thickness t31 of the second vertical portion 131_V2 of the interfacial insulating film in the second direction D2. The thickness t12 of the horizontal portion 132_H of the high-dielectric constant insulating film in the third direction D3 may be equal to the thickness t32 of the second vertical portion 132_V2 of the high-dielectric constant insulating film in the second direction D2.

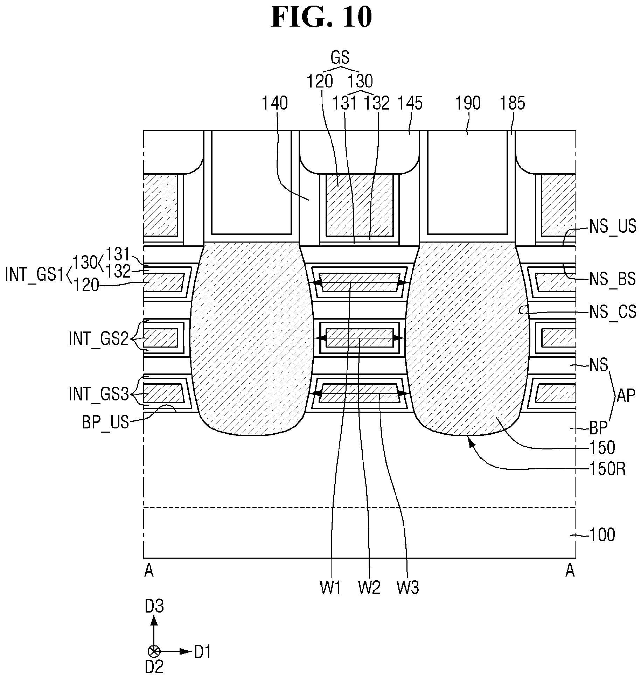

FIG. 10 is a diagram for explaining a semiconductor device according to some embodiments. For convenience of explanation, points different from those described referring to FIGS. 1 to 5 will be described.

Referring to FIG. 10, in the semiconductor device according to some embodiments, the widths of the inter-gate structures INT_GS1 and INT_GS2 disposed between the sheet patterns NS adjacent to each other in the third direction D3 may be different from each other.

For example, the width W1 of the first inter-gate structure INT_GS1 in the first direction D1 may be greater than the width W2 of the second inter-gate structure INT_GS2 in the first direction D1.

The width W2 of the second inter-gate structure INT_GS2 in the first direction D1 may be smaller than the width W3 of the third inter-gate structure INT_GS2 in the first direction D1.

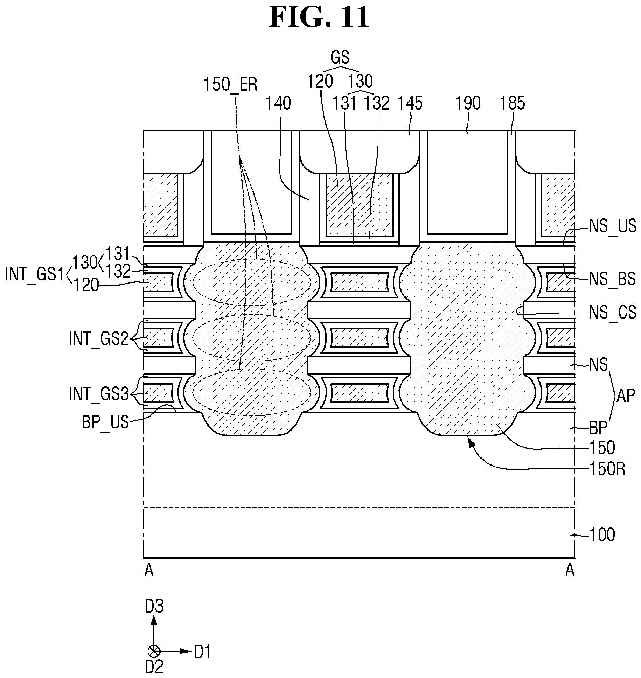

FIG. 11 is a diagram for explaining the semiconductor device according to some embodiments. For convenience of explanation, the elements described referring to FIGS. 1 to 5 will be omitted.

Referring to FIG. 11, in a semiconductor device according to some embodiments, the source/drain pattern 150 may include a plurality of width expansion regions 150 ER.

The side walls of the source/drain pattern 150 may have a wavy shape. The width expansion region 150_ER of each source/drain pattern may be disposed above the upper surface BP_US of the lower pattern.

The width expansion region 150_ER of the source/drain pattern may be defined between the nanosheets NS adjacent to each other in the third direction D3. The width expansion region 150_ER of the source/drain pattern may be defined between the lower pattern BP and the nanosheet NS. The width expansion region 150_ER of the source/drain pattern may extend between the nanosheets NS adjacent to each other in the third direction D3.

For example, the width expansion region 150_ER of the source/drain pattern is disposed between the nanosheet NS, and may be defined between the inter-gate structures INT_GS1 and INT_GS2 adjacent to each other in the first direction D1. The width expansion region 150_ER of the source/drain pattern is disposed between the nanosheet NS and the lower pattern BP, and may be defined between the third inter-gate structures INT GS3 adjacent to each other in the first direction D1.

The width expansion region 150 ER of each source/drain pattern may include a portion in which the width in the first direction D1 increases and a portion in which the width in the first direction D1 decreases, when the width is measured along a straight line extending in the third direction D3 away from the upper surface BP US of the lower pattern BP toward the interlayer insulating film 190. For example, the width of the width expansion region 150 ER of the source/drain pattern may increase and then decrease, when the width is measured along a straight line extending in the third direction D3 away from the upper surface BP US of the lower pattern BP toward the interlayer insulating film 190.

In the width expansion region 150 ER of each source/drain pattern, the point where the width of the width expansion region 150 ER of the source/drain pattern is maximum is disposed between the nanosheet NS and the lower pattern BP or between the nanosheets NS adjacent to each other in the third direction D3.

The side walls of the inter-gate structures INT GS1, INT GS2, and INT GS3 that form a boundary with the source/drain pattern 150 may be concave curved surfaces.

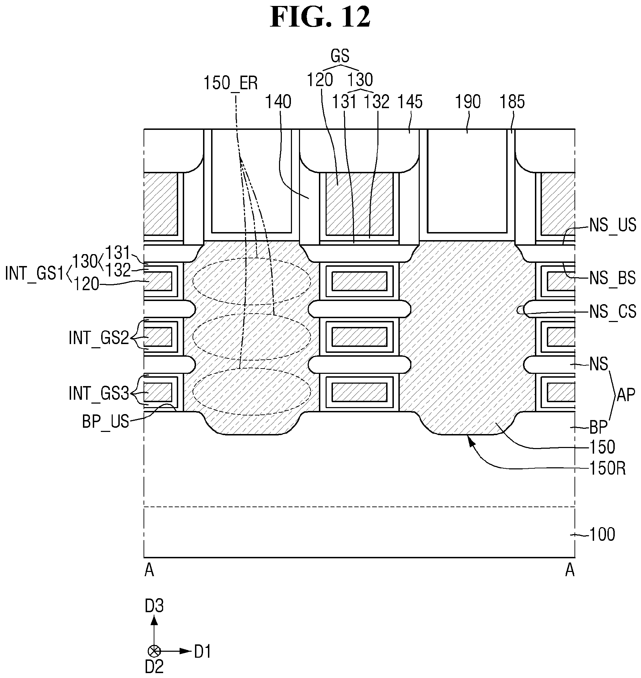

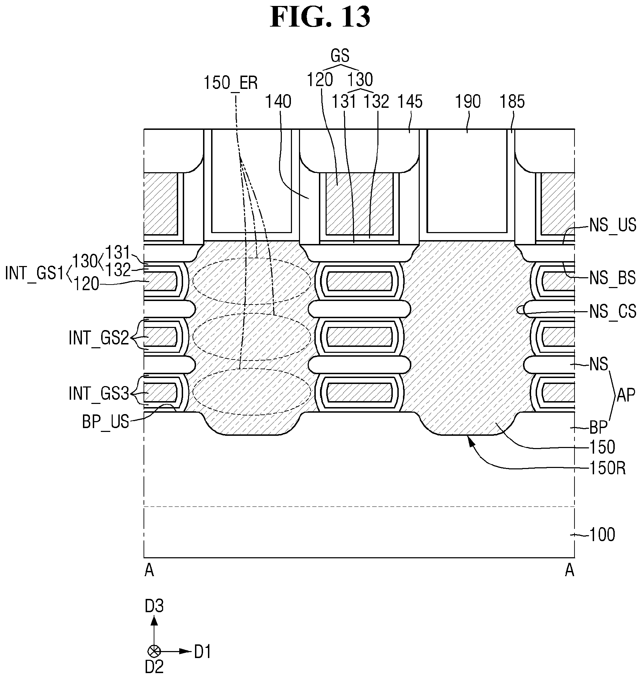

FIG. 12 is a diagram for explaining a semiconductor device according to some embodiments. FIG. 13 is a diagram for explaining the semiconductor device according to some embodiments. For convenience of explanation, points different from those described referring to FIG. 11 will be described.

Referring to FIG. 12, in a semiconductor device according to some embodiments, the side walls of the inter-gate structures INT_GS1, INT_GS2 and INT_GS3 that form a boundary with the source/drain pattern 150 may be flat.

In the cross-sectional view taken along the first direction D1 in which the lower pattern BP extends, the boundary between the inter-gate structures INT_GS1, INT_GS2 and INT_GS3 and the source/drain pattern 150 may be flat.

The width of the width expansion region 150_ER of the source/drain pattern may increase and then be kept constant, and then decrease, when the width is measured along a straight line extending in the third direction D3 away from the upper surface BP_US of the lower pattern BP.

Referring to FIG. 13, in a semiconductor device according to some embodiments, the side walls of the inter-gate structures INT_GS1, INT_GS2 and INT_GS3 that form a boundary with the source/drain pattern 150 may be convex curved surfaces.

In the cross-sectional view taken along the first direction D1 in which the lower pattern BP extends, the inter-gate structures INT_GS1, INT_GS2 and INT_GS3 may protrude toward the source/drain pattern 150, similarly to the sheet pattern NS. However, the inter-gate structures INT_GS1, INT_GS2, and INT_GS3 do not protrude from the connecting surface NS_CS of the sheet pattern.

The width of the width expansion region 150_ER of the source/drain pattern may increase, decrease, and then decrease when the width is measured along a straight line extending in the third direction D3 away from the upper surface BP_US of the lower pattern BP toward the interlayer insulating film 190.

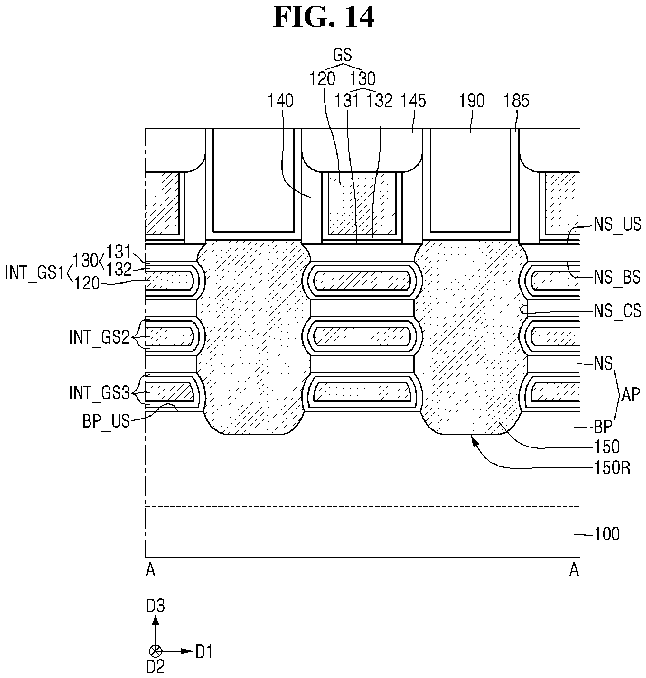

FIG. 14 is a diagram for explaining a semiconductor device according to some embodiments. For convenience of explanation, points different from those described referring to FIGS. 1 to 5 will be described.

Referring to FIG. 14, in the semiconductor device according to some embodiments, the inter-gate structures INT_GS1, INT_GS2 and INT_GS3 may protrude in first direction D1 toward the source/drain pattern 150 beyond the connecting surface NS_CS of at least one or more sheet patterns.

For example, a part of the first inter-gate structure INT_GS1 and a part of the second inter-gate structure INT_GS2 may protrude toward the source/drain pattern 150 beyond the connecting surface from NS_CS of the sheet pattern between the first inter-gate structure INT_GS1 and the second inter-gate structure INT_GS2.

A part of the second inter-gate structure INT_GS2 and a part of the third inter-gate structure INT_GS3 may protrude toward the source/drain pattern 150 beyond the connecting surface NS_CS of the sheet pattern between the second inter-gate structure INT_GS2 and the third inter-gate structure INT_GS3.

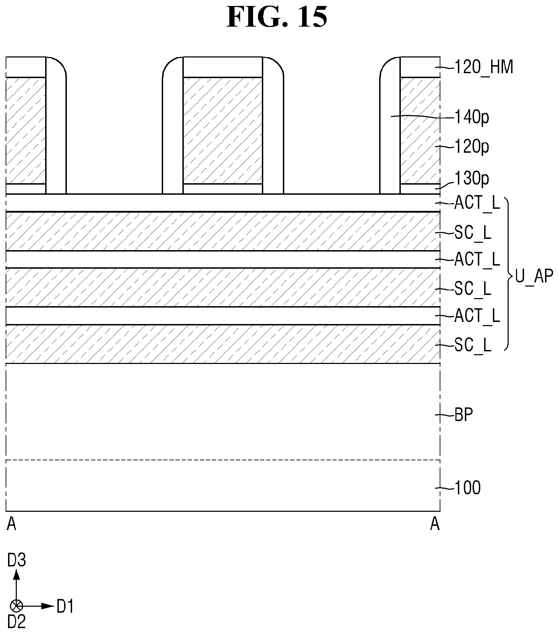

FIGS. 15 to 20 are intermediate stage diagrams for explaining a method for manufacturing a semiconductor device according to some embodiments. FIGS. 15 to 20 may be cross-sectional views taken along A-A of FIG. 1. The following manufacturing method will be described from the viewpoint of the cross-sectional view.

Referring to FIG. 15, the lower pattern BP and an upper pattern structure U_AP may be formed on the substrate 100.

The upper pattern structure U_AP may be disposed on the lower pattern BP. The upper pattern structure U_AP may include a sacrificial pattern SC_L and an active pattern ACT_L that are alternately stacked on the lower pattern BP. For example, the sacrificial pattern SC_L may include or may be a silicon-germanium film. The active pattern ACT_L may include or may be a silicon film.

Subsequently, a dummy gate insulating film 130p, a dummy gate electrode 120p, and a dummy gate capping film 120 HM may be formed on the upper pattern structure U AP. The dummy gate insulating film 130p may include or may be formed of, for example, but is not limited to, silicon oxide. The dummy gate electrode 120p may include or may be formed of, for example, but is not limited to, polysilicon. The dummy gate capping film 120 HM may include or may be formed of, for example, but is not limited to, silicon nitride.

A pre-gate spacer 140p may be formed on the side walls of the dummy gate electrode 120p.

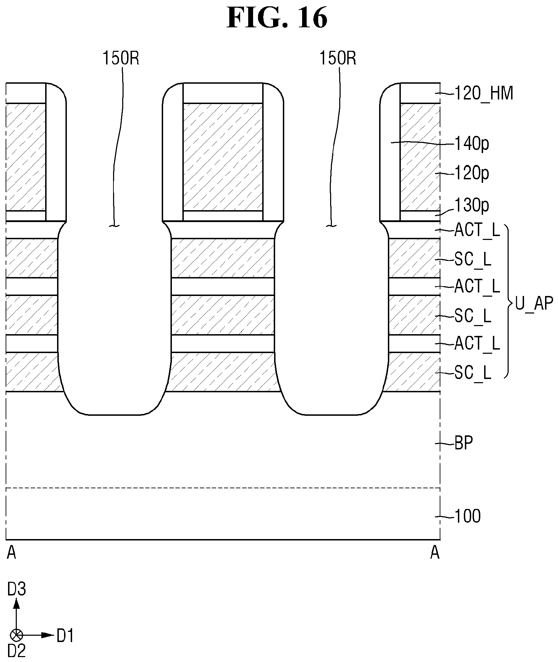

Referring to FIG. 16, a source/drain recess 150R may be formed inside the upper pattern structure U AP, using the dummy gate electrode 120p as a mask.

A part of the source/drain recess 150R may be formed inside the lower pattern BP.

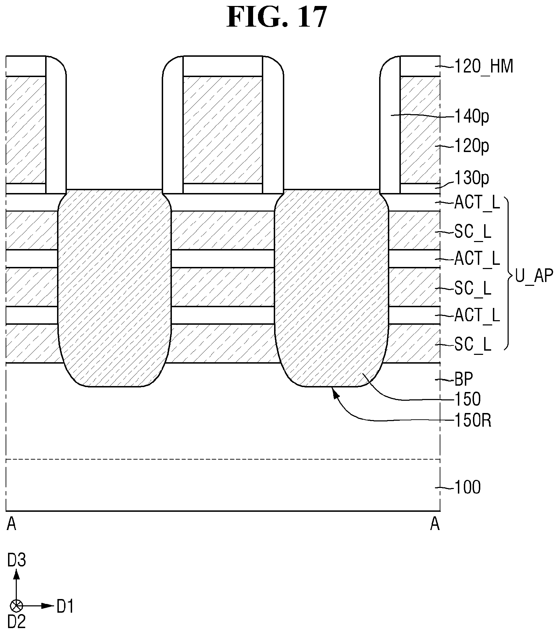

Referring to FIG. 17, the source/drain pattern 150 may be formed inside the source/drain recess 150R.

The source/drain pattern 150 may be formed on the lower pattern BP. The source/drain pattern 150 may be in direct contact with the sacrificial pattern SC L and the active pattern ACT L.

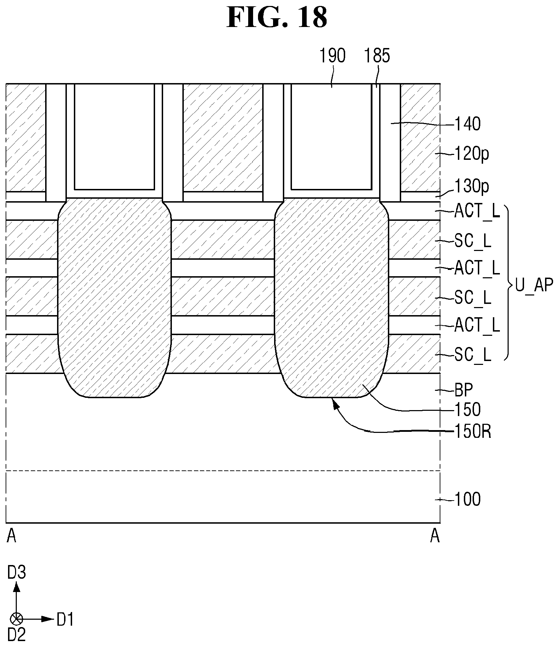

Referring to FIG. 18, an etching stop film 185 and an interlayer insulating film 190 are sequentially formed on the source/drain pattern 150.

Subsequently, a part of the interlayer insulating film 190, a part of the etching stop film 185, and the dummy gate capping film 120 HM are removed to expose the upper surface of the dummy gate electrode 120p. The gate spacer 140 may be formed, while the upper surface of the dummy gate electrode 120p is exposed.

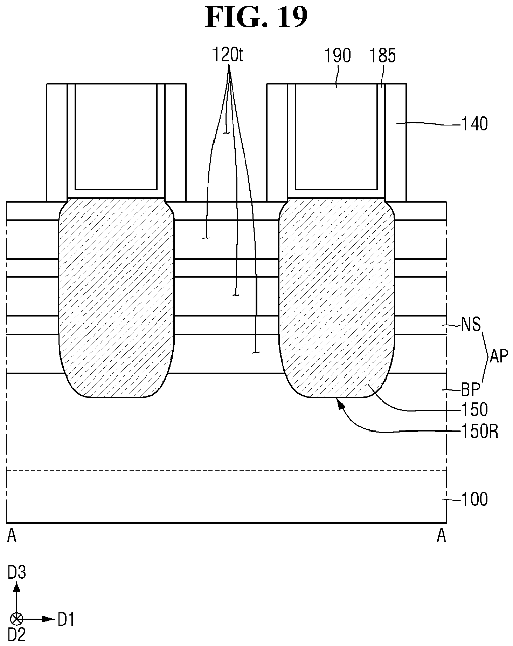

Referring to FIG. 19, the dummy gate insulating film 130p and the dummy gate electrode 120p may be removed to expose the upper pattern structure U AP between the gate spacers 140.

After that, the sacrificial pattern SC L may be removed to form the sheet pattern NS1. As a result, a gate trench 120t is formed between the gate spacers 140.

Further, an active pattern AP including the lower pattern BP and the sheet pattern NS is formed.

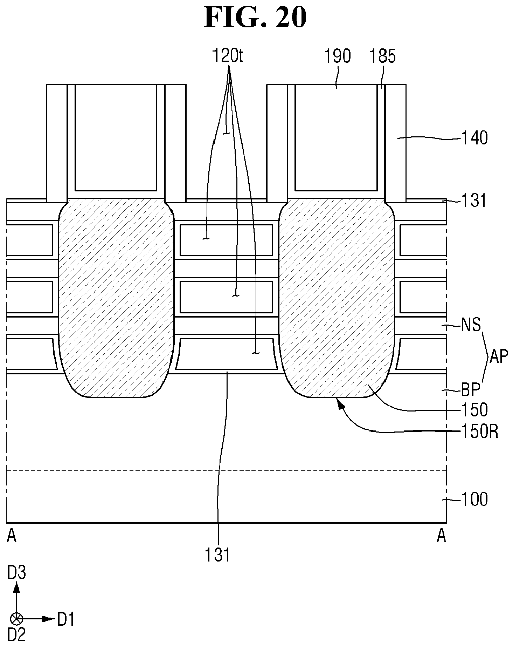

Referring to FIG. 20, an interfacial insulating film 131 may be formed along the upper surface and the lower surface of the sheet pattern NS exposed by the gate trench 120t.

The interfacial insulating film 131 may be formed along the source/drain pattern 150 exposed by the gate trench 120t.

The thickness of the interfacial insulating film 131 extending along the source/drain pattern 150 is thicker than the thickness of the interfacial insulating film 131 extending along the upper surface and the lower surface of the sheet pattern NS.

For example, the thickness of the formed interfacial insulating film 131 may vary, depending on the constituent components of the exposed semiconductor material, the type of doped impurities, the concentration of impurities, and the like.

Next, referring to FIG. 2, the high-dielectric constant insulating film 132 and the gate electrode 120 may be formed inside the gate trench 120t. Further, the gate capping pattern 145 may be formed.

In concluding the detailed description, those skilled in the art will appreciate that many variations and modifications may be made to the preferred embodiments without substantially departing from the principles of the present inventive concept. Therefore, the disclosed preferred embodiments of the invention are used in a generic and descriptive sense only and not for purposes of limitation.

## Claims

1. A semiconductor device comprising:
an active pattern which includes:
a lower pattern extending in a first direction, and
a plurality of sheet patterns spaced apart from the lower pattern in a second direction perpendicular to an upper surface of the lower pattern, each of the plurality of sheet patterns including an upper surface and a lower surface opposite to each other in the second direction;
a gate structure which is disposed on the lower pattern and includes a gate electrode and a gate insulating film, the gate electrode and the gate insulating film surrounding each of the plurality of sheet patterns; and
a source/drain pattern which is disposed on at least one side of the gate structure,
wherein the gate structure includes a plurality of inter-gate structures,
wherein a lowermost inter-gate structure of the plurality of inter-gate structures is disposed between the lower pattern and a lowermost sheet pattern of the plurality of sheet patterns,
wherein each of other inter-gate structures of the plurality of inter-gate structures is between two sheet patterns, adjacent to each other in the second direction, of the plurality of sheet patterns,
wherein the gate structure contacts the source/drain pattern,
wherein the gate insulating film includes:
a horizontal portion extending along an upper surface of each sheet pattern of the plurality of sheet patterns and a lower surface of each sheet pattern of the plurality of sheet patterns, and
a first vertical portion extending along the source/drain pattern, and
wherein a thickness, in the second direction, of the horizontal portion of the gate insulating film is different from a thickness, in the first direction, of the first vertical portion of the gate insulating film.

2. The semiconductor device of claim 1,
wherein the thickness, in the second direction, of the horizontal portion of the gate insulating film is smaller than the thickness, in the first direction, of the first vertical portion of the gate insulating film.

3. The semiconductor device of claim 1,
wherein the gate insulating film includes an interfacial insulating film and a high-dielectric constant insulating film,
wherein the high-dielectric constant insulating film is disposed between the interfacial insulating film and the gate electrode, and
wherein a thickness, in the second direction, of the interfacial insulating film in the horizontal portion of the gate insulating film is different from a thickness, in the first direction, of the interfacial insulating film in the first vertical portion of the gate insulating film.

4. The semiconductor device of claim 3,
wherein the thickness, in the second direction, of the interfacial insulating film in the horizontal portion of the gate insulating film is smaller than the thickness, in the first direction, of the interfacial insulating film in the first vertical portion of the gate insulating film.

5. The semiconductor device of claim 1,
wherein each of the plurality of sheet patterns includes side walls,
wherein in each of the plurality of sheet patterns, side walls connect an upper surface to a lower surface,
wherein the gate insulating film includes a second vertical portion extending along the side walls of each of the plurality of sheet patterns, and
wherein the thickness, in the second direction, of the horizontal portion of the gate insulating film is smaller than a thickness, in the first direction, of the second vertical portion of the gate insulating film.

6. The semiconductor device of claim 5,
wherein the gate insulating film includes an interfacial insulating film and a high-dielectric constant insulating film,
wherein the high-dielectric constant insulating film is disposed between the interfacial insulating film and the gate electrode, and
wherein a thickness, in the second direction, of the interfacial insulating film in the horizontal portion of the gate insulating film is smaller than a thickness, in the first direction, of the interfacial insulating film in the second vertical portion of the gate insulating film.

7. The semiconductor device of claim 1,
wherein each of the plurality of sheet patterns includes side walls,
wherein in each of the plurality of sheet patterns, side walls connect an upper surface to a lower surface,
wherein the gate insulating film includes a second vertical portion extending along the side walls of each of the plurality of sheet patterns, and
wherein the thickness, in the second direction, of the horizontal portion of the gate insulating film is equal to a thickness, in the first direction, of the second vertical portion of the gate insulating film.

8. The semiconductor device of claim 1,
wherein the source/drain pattern includes a plurality of width expansion regions that are spaced apart from each other in the second direction,
wherein each of the plurality of width expansion regions has curved sidewalls, and
wherein a width of each of the plurality of width expansion regions, in the first direction, between the curved sidewalls varies when the width is measured along a straight line extending in the second direction away from the upper surface of the lower pattern.

9. The semiconductor device of claim 8,
wherein the plurality of width expansion regions have maximum widths at regions between the lower pattern and a lowermost sheet pattern of the plurality of sheet patterns, and between two adjacent sheet patterns, in the second direction, of the plurality of sheet patterns.

10. The semiconductor device of claim 1,
wherein the plurality of inter-gate structures include a first inter-gate structure and a second inter-gate structure,
wherein the plurality of sheet patterns include a first sheet pattern disposed between the first inter-gate structure and the second inter-gate structure,
wherein the first sheet pattern includes a boundary surface that is in contact with the source/drain pattern, and
wherein a part of the first inter-gate structure and a part of the second inter-gate structure protrude toward the source/drain pattern from the boundary surface of the first sheet pattern.

11. A semiconductor device comprising:
an active pattern which includes:
a lower pattern extending in a first direction, and
a plurality of sheet patterns spaced apart from the lower pattern in a second direction perpendicular to an upper surface of the lower pattern, each of the plurality of sheet patterns including an upper surface and a lower surface opposite to each other in the second direction;
a gate structure which is disposed on the lower pattern and includes a gate electrode and a gate insulating film, the gate electrode and the gate insulating film surrounding each of the plurality of sheet patterns; and
a source/drain pattern which is disposed on at least one side of the gate structure,
wherein the gate structure includes a plurality of inter-gate structures,
wherein a lowermost inter-gate structure of the plurality of inter-gate structures is disposed between the lower pattern and a lowermost sheet pattern of the plurality of sheet patterns,
wherein each of other inter-gate structures of the plurality of inter-gate structures is disposed between corresponding two sheet patterns, adjacent to each other in the second direction, of the plurality of sheet patterns,
wherein the gate insulating film includes:
an interfacial insulating film, and
a high-dielectric constant insulating film disposed between the interfacial insulating film and the gate electrode,
wherein the interfacial insulating film includes:
a horizontal portion extending along an upper surface of each of the plurality of sheet patterns and a lower surface thereof, and
a first vertical portion extending along the source/drain pattern, and
wherein a thickness, in the second direction, of the horizontal portion of the interfacial insulating film is different from a thickness, in the first direction, of the first vertical portion of the interfacial insulating film.

12. The semiconductor device of claim 11,
wherein the thickness, in the second direction, of the horizontal portion of the interfacial insulating film is smaller than the thickness, in the first direction, of the first vertical portion of the interfacial insulating film.

13. The semiconductor device of claim 11,
wherein the interfacial insulating film contacts the source/drain pattern.

14. The semiconductor device of claim 11,
wherein the first vertical portion of the interfacial insulating film includes:
a first region contacting the source/drain pattern, and
a second region disposed on the first region of the first vertical portion of the interfacial insulating film,
wherein the source/drain pattern is doped with a first element other than silicon, and
wherein a concentration of the first element in the first region of the first vertical portion of the interfacial insulating film is higher than a concentration of the first element in the second region of the first vertical portion of the interfacial insulating film.

15. A semiconductor device comprising:
an active pattern which includes:
a lower pattern extending in a first direction, and
a plurality of sheet patterns spaced apart from the lower pattern in a second direction perpendicular to an upper surface of the lower pattern, each of the plurality of sheet patterns including an upper surface and a lower surface opposite to each other in the second direction;
a gate structure which is disposed on the lower pattern and includes a gate electrode and a gate insulating film, the gate electrode and the gate insulating film surrounding each of the plurality of sheet patterns;
a gate spacer disposed on opposite side walls of the gate structure; and
a source/drain pattern which is disposed on at least one side of the gate structure,
wherein the gate insulating film includes:
an interfacial insulating film, and
a high-dielectric constant insulating film disposed between the interfacial insulating film and the gate electrode,
wherein the interfacial insulating film does not extend along side walls of the gate spacer,
wherein the high-dielectric constant insulating film extends along the side walls of the gate spacer,
wherein the interfacial insulating film includes:
a horizontal portion extending along an upper surface of each of the plurality of sheet patterns and a lower surface thereof, and
a first vertical portion extending along the source/drain pattern and contacting the source/drain pattern, and
wherein a thickness, in the second direction, of the horizontal portion of the interfacial insulating film is different from a thickness, in the first direction, of the first vertical portion of the interfacial insulating film.
